# EUROPEAN PATENT APPLICATION

(11) **EP 4 496 334 A1**
(43) Date of publication of application: **22.01.2025**
(21) Application number: 23382750.0
(22) Date of filing: 20.07.2023
(51) Int. Cl.: H04N 23/81, B60R 1/00, G02B 27/00, G03B 17/55, H04N 23/51, H04N 23/54, H04N 23/55, G01N 21/94, G01N 21/958, G01S 7/497, B60R 11/00

(54) **OPTICAL ASSEMBLY AND RELATED METHODS**

(71) Applicant: Ficosa Automotive, S.L.U., 08232 Viladecavalls (ES)
(72) Inventor: CABALLERO ARIAS, Javier, 08232 VILADECAVALLS (ES); CHAMADOIRA, Sara, 08232 VILADECAVALLS (ES)
(74) Representative: ZBM Patents - Zea, Barlocci & Markvardsen

(57) **Abstract**

The optical assembly (10) comprises an optical body (100), a housing (200) to receive the optical body (100), an electronics carrier (500), and an electronic component (300) coupled to the electronics carrier (500). The electronic component (300) comprises a light source (300') to emit light to the optical body (100) and a light receiver (400) to receive light reflected from the optical body (100) such that optical contamination (S) on the optical body (100) is detected. The optical assembly (10) is a lens assembly or a camera arrangement. The method of making comprises providing a housing (200) to receive the optical body (100), coupling the electronic component (300) to the electronics carrier (500), providing the electronics carrier (500) behind at least one optical element (110) of the optical body (100) along the optical axis (O), and inserting of the electronics carrier (500) inside the housing (200) such that the electronics carrier (500) and the electronic component (300) are arranged between optical elements (110).

## Description

The present disclosure relates to an optical assembly, such as for example a lens assembly for camera arrangements, or a camera arrangement for vehicle visual systems and many other applications. The present disclosure further concerns to related methods such as methods of making said optical assemblies and methods of detecting optical contamination on optical assemblies.

### BACKGROUND

Camera arrangements are commonly employed in visual systems, for example in the automotive field, and in many other applications where images are to be acquired from surrounding environments, such as in motor vehicles. In the latter case, visual systems are commonly associated with rear view mirrors, backup cameras, front and rear-view cameras, top-view systems, etc. Visual systems include a camera arrangement and an electronic control unit (ECU) typically fitted in vehicle.

Known camera arrangements comprise a lens assembly that includes an optical body, e.g., a lens, with at least one optical element fitted within a lens barrel or lens assembly holder. An image sensor is coupled to an electronics carrier, in optical communication with the optical body. The image sensor should be arranged in optical alignment with the optical body for proper image quality.

However, it is not enough for the optical body and the image sensor to be arranged in optical alignment with each other for proper image quality. Optical contamination involving impediments to light passing through the optical elements may occur as a result of the presence of dirtiness, dust accumulation, mud splashes, water droplets, frost, snow, ice sheets, etc. Image quality may be thus adversely affected resulting in captured images not representing a true image within the field of view. In the automotive field, for example, driving safety and comfort may be adversely affected by such optical contamination.

There have been a number of attempts in prior art camera arrangements to provide optical elements with reduce or no optical contamination for the purpose of obtaining optimal image quality. However, they have been shown to be still inefficient. There is still a need for simple, cost-effective, and versatile optical systems for detecting optical contamination that can be effectively used with optical assemblies in camera arrangements for visual systems.

### SUMMARY

An optical assembly and related methods are disclosed herein.

The present optical assembly comprises an optical body, a housing adapted at least to receive the optical body, an electronics carrier, and an electronic component coupled to the electronics carrier.

The optical assembly may be a lens assembly or a camera arrangement.

In the following, reference will be made to an optical axis. The optical axis corresponds, within the meaning of the present disclosure, to a straight line defined by the optical body passing through its geometrical centre that creates a path along which the light is propagated through optical elements. Thus, the optical axis is an imaginary line that defines the path along which light propagates through the optical assembly.

In use, the optical body is intended to be in optical communication with an image sensor so as to acquire a captured image from an exterior field of view of a vehicle extending at least outside the vehicle. The image sensor may not necessarily be part of the optical assembly. For example, the image sensor may be arranged out of the optical assembly when said optical assembly is lens assembly.

The electronics carrier may comprise mutually opposite first and second main surfaces connected through an edge. The electronic component may be preferably coupled, e.g., attached, to said first main surface of the electronics carrier. The electronics carrier may be suitable for carrying electronics for operation of the optical assembly. The electronics carrier may comprise one or more printed circuit boards, PCBs, and optionally any other substrate having electronics.

It may be preferred that the electronic component is arranged between a main surface of the electronics carrier and a portion of the optical body, as it will be described in detail further below. The optical body may comprise one or more optical elements, e.g., one or more lenses, wherein the electronic component may be arranged below an optical element along the optical axis. It is more preferred the optical body comprises at least two optical elements between which the electronic component is arranged.

The electronic component may comprise one or more light sources. The light source may be configured to emit light to the optical body. Further, the one or more light source may comprise a LED (light-emitting diode) device. The light source may be configured to emit light at a wavelength below 400 nm or above 780 nm. Preferably, the light source may be configured to emit light at a wavelength of 760-800 nm, or at a wavelength of 920-960 nm, or at a wavelength of 1110-1150 nm, or at a wavelength of 1380-1420 nm, or even at a wavelength of 1880-1920 nm. The light source may be configured to emit light towards the optical body so that the optical body reflects light generated by the light source when optical contamination, e.g., speckles, is located on a surface (e.g. exterior surface) of the optical body. As used herein, an exterior surface of the optical body refers to a surface thereof that is in contact with the exterior environment. The exterior surface is where optical contamination to be detected and removed is deposited.

The electronic component may comprise one or more light receivers. The light receiver may be configured to receive light reflected from the optical body. Further, the light receiver may comprise a photo detector, for example, a CCD (charge-coupled device) sensor. Preferably, the light receiver may further comprise broadband detectors including ultra-violet detectors configured to detect light under 400 nm and/or infrared detectors configured to operate over 780 nm, depending on the light source wavelength. More preferably, the light receivers may be configured to receive and/or detect light at a wavelength of 760-800 nm, or at a wavelength of 920-960 nm, or at a wavelength of 1110-1150 nm, or at a wavelength of 1380-1420 nm, or even at a wavelength of 1880-1920 nm.

Thus, as opposed to known devices where light sources and/or light receivers are directly attached to a lens barrel, the present optical assembly provides light sources and/or light receivers directly attached to an electronics carrier. As result, a simple and fast assembly process is advantageously obtained, which is of particular relevance in mass production.

The housing of the optical assembly may enclose at least a portion of the optical body, the electronics carrier and the electronic component. Further, the housing may comprise a first coupling surface for receiving at least one of the electronics carrier, and an attaching means for fixing the electronics carrier in the housing. Where attaching means are provided, they may be adhesive means, welding means, fastening means, such as screws for attaching the electronics carrier to the housing, or a clamping pressure means, such as an inner surface of the housing for sandwiching the electronics carrier.

The housing may further comprise a second coupling surface for receiving the optical body. More preferably, the second coupling surface of the housing may be particularly adapted for attaching the optical body and the housing to each other.

Advantageously, the housing may comprise a passageway formed therein for receiving at least one portion of the electronics carrier.

The optical body may extend from a top end to a bottom end thereof. Preferably, the top end of the optical body may be at or near a first end of the housing. As stated above, the optical body may comprise a plurality of optical elements arranged one after the other along the optical axis. Preferably, the electronics carrier may be thus arranged between two optical elements. The top end of the optical body may be a top end of the first optical element. The bottom end of the optical body may be a bottom end of the last optical element. In use, the first optical element may be the optical element arranged closest to the exterior environment. This is, when the lens assembly is mounted in the camera arrangement, the first optical element may be the optical element arranged furthest away from the image sensor, and the last optical element may be the optical element arranged closest to the image sensor.

More preferably, the electronics carrier and the electronic component may be at least partially arranged between the first optical element and the second optical element.

The optical body may include a peripheral surface connecting the top end of the optical body and the bottom end of the optical body. Said peripheral surface may comprise a first diameter and a second diameter. The first diameter may be greater than the second diameter. Preferably, the first diameter may be at or near the top end of the optical body. Preferably, the second diameter of the peripheral surface may be closer to the bottom end of the optical body than the first diameter of the peripheral surface. More preferably, the second diameter of the peripheral surface may be arranged between the top end and the bottom end of the optical body. It may be more preferred that the housing may be arranged at least around the second diameter of the peripheral surface.

When the optical assembly is the lens assembly, the housing may be a lens barrel. The optical body may be a lens body, wherein the lens body may comprise one or more optical elements. Preferably, the lens body may comprise at least two optical elements between which the electronic component is arranged. In this way, the lens assembly may comprise the above-mentioned lens body and the lens barrel. Thus, the lens barrel may be adapted to receive the lens body. Preferably, the lens barrel may be adapted for receiving a number of optical elements arranged one after the other along the direction of the optical axis. In use, the lens assembly may be particularly configured for guiding the light into the image sensor. For this purpose, when the lens assembly is mounted in the camera arrangement, the lens assembly and the image sensor are in optical communication, that is, they are optically aligned. The image sensor may preferably be arranged out of the optical body, more preferably out of the lens barrel.

The lens barrel of the lens assembly may enclose at least a portion of the optical body, the electronics carrier, and the electronic component. Further, the lens barrel may comprise the first coupling surface for receiving at least one of the electronics carrier, and an attaching means for fixing the electronics carrier within the lens barrel. The lens barrel may comprise the second coupling surface that may be particularly adapted to receive the optical body. As stated above, said second coupling surface may be particularly adapted for attaching the lens barrel and the lens body to each other. Preferably, the top end of the optical body may be at or near a first end of the lens barrel. It may be more preferred that the lens barrel may be arranged at least around the second diameter of the peripheral surface.

The lens barrel may comprise the above-mentioned passageway for receiving at least one portion of the electronics carrier. Further, the passageway may extend parallel to the optical axis. Preferably, the passageway may be arranged extending through a lateral side of the lens barrel.

It is preferred that the electronics carrier may be arranged within the lens assembly at least partially extending around the optical body and between opposite ends of said optical body. Preferably, the electronic component is arranged between the first main surface of the electronics carrier and a portion of the optical body. A portion of the lens body may be arranged extending through the electronics carrier. For this purpose, the electronics carrier may comprise a through opening which the lens body or a portion thereof is allowed to extend. This is, the electronics carrier is crossed by the lens body.

It is preferred that the electronics carrier may be an electronics carrier, e.g., a flexible electronics carrier, comprising a first portion extending in a direction substantially parallel to the optical axis of the optical body, and a second portion at least partially contained in a plane that is substantially perpendicular to the optical axis of the optical body. Further, the passageway formed in the lens barrel may be adapted for receiving the first portion of the electronics carrier.

When the optical assembly is the camera arrangement, the housing may be a camera housing. The camera housing may comprise a first housing part, e.g. a front housing, and a second housing part, e.g. a back housing, adapted for attaching to each other defining therein an interior space. The camera housing may enclose the electronics carrier and the electronic component. More preferably, the housing may enclose at least a portion of the optical body. The camera arrangement may further comprise an image sensor and a lens assembly that includes the optical body. The lens assembly may comprise a lens barrel for receiving the optical body. Alternatively, the camera housing may comprise a lens barrel. That is, the lens barrel may be part of or be attached to the camera housing. As explained, the camera arrangement may be particularly adapted to receive the optical body. The camera arrangement may be adapted for attaching the lens assembly and the camera housing to each other. More preferably, the camera housing may comprise the above-mentioned second coupling surface particularly adapted for attaching the lens barrel to the camera housing.

Preferably, the camera housing may comprise the first coupling surface for receiving at least one of the electronics carrier, and the attaching means for fixing the electronics carrier in the camera housing. Where attaching means are provided, they may be adhesive means, welding means, fastening means, such as screws for attaching the electronics carrier to a camera front housing, or a clamping pressure means, such as front and back housing surfaces sandwiching the electronics carrier.

The image sensor may be coupled, e.g. attached, to the electronics carrier and in optical communication with the lens assembly. The optical body may be particularly configured for guiding the light into the image sensor. For this purpose, when the optical body is mounted in the camera arrangement the optical body and the image sensor are in optical communication, that is, they are optically aligned. The image sensor may preferably be arranged out of the optical body and within the camera housing. Preferably, the electronics carrier, e.g., the second portion of the electronics carrier, may comprise a first segment and a second segment. More preferably, the first segment may comprise a first printed circuit board and a second segment may comprise a second printed circuit board. Optionally, said first and second printed circuit boards may have portions arranged parallel to each other. Both may be arranged inside the optical assembly. Further, at least a portion of the second printed circuit board may be arranged above the first printed circuit along the optical axis. The first printed circuit board may comprise the electronic component. Also, the second printed circuit board may be in electrical connection to a heating element as explained below.

Furthermore, the electronics carrier may comprise an imager printed circuit board that includes the image sensor. Said imager printed circuit board may be attached to the lens barrel or to the camera housing. At least a portion of the imager printed circuit board may be arranged below the first printed circuit along the optical axis. Alternatively, it may also be possible the imager printed circuit board may comprise the electronic component and the image sensor.

It is envisaged that the optical assembly may further comprise a heating element. Said heating element includes a conductive body for resistive heating of at least a portion of the optical body as an electric current flows through. It is preferred that said conductive body includes an optically transparent coating applied to the optical body with an optically transparent conductive layer. Said configuration effectively provides resistive heating as an electric current flows through. Heat supplied by the heating element advantageously allows optical contamination such as dirtiness, dust accumulation, mud splashes, water droplets, fog, condensation, frost, snow, ice sheets, etc. present on the optical body to be easily removed, e.g., detached. Particularly, optical contamination that contains water.

Within the meaning of the present disclosure, the terms layer and coating both refer herein to a thin sheet that covers or lies over at least a portion of a surface of an object.

The heating element is electrically connected to the above-mentioned electronics carrier. For this purpose, the optical assembly may further comprise an electrical connecting means for electrically connecting the electronics carrier and the heating element.

The electronics carrier preferably includes at least one electric track for supplying electric power to the heating element. Further, the electronics carrier preferably includes at least one electric track for supplying electric power to the electronic component.

According to an aspect of the present invention, a method of making an optical assembly is also disclosed herein.

The method comprises providing a housing adapted to receive an optical body defining an optical axis, as mentioned above. The method further comprises coupling an electronic component to an electronics carrier.

The electronic component comprises at least one of:
- one or more light sources configured to emit light, e.g., a light beam, towards the optical body with the optical body configured to reflect light from the light source when optical contamination is located on the surface of the optical body; and
- one or more light receivers configured to receive the light, e.g., the light beam, reflected by the optical body such that optical contamination on the surface of the optical body is detected.

The method further comprises providing the electronics carrier behind at least one optical element of the optical body along an optical axis of the optical body.

Preferably, the method may further comprise inserting at least one portion of the electronics carrier inside the housing such that the electronics carrier and the electronic component are arranged between two optical elements of the optical body.

The optical assembly to be made by the method disclosed herein may be an optical assembly as described above.

According to an aspect of the present invention, a method of detecting optical contamination on an optical assembly is also disclosed herein. The method comprises the steps of emitting, by a light source, a light, e.g., a beam, towards an optical body, receiving, by a light receiver, light, e.g., the light beam, towards the optical body, and detecting optical contamination located on the surface of the optical body. The optical body is configured to reflect light from the light source when optical contamination is located on a surface of the optical body. The method may further comprise the step of acquiring a video feed from an exterior field of view of a vehicle extending at least outside the vehicle. The acquired video feed may operate at least at 15 frames per second (fps), preferably, above 30 fps.

The method preferably further comprises generating a heating instruction when optical contamination has been detected, and providing electric current to a heating element that is electrically conductive for resistive heating of at least a portion of the optical body as an electric current flows through.

More in detail, according to the method described above, detection of the optical contamination in a surface of the optical element is carried out as follows.

The light sources may emit light, i.e., a light beam, towards the optical element. When a surface, i.e., an exterior surface of the optical body is clean, i.e., no optical contamination such as dirtiness, dust accumulation, mud splashes, water droplets, fog, condensation, frost, snow, ice sheets, etc. is present on the optical body, the emitted light in this case simply passes through the optical element and may be lost to the exterior of the optical element. When optical contamination is present on said surface of the optical body, the emitted light in this case is reflected at the location of the optical contamination so that the emitted light does not pass through the optical element but instead is reflected or scattered by the optical element. When reflected light is received by the light receivers, it is determined that the optical body has optical contamination and corrective action(s) such as the activation of a heating element, activation of an automatic cleaning system, triggering of an alarm for manual cleaning, etc. may be performed in response. Light received by the light receiver corresponds to light reflected and scattered by dirt particles instead of specular reflection.

Thus, with the above-described optical assembly, an optical contamination detection function is provided by said electronic component. Said optical contamination detection function may be combined by and coordinated with an automatic cleaning system. Said automatic cleaning system may include a heating system. For this purpose, the optical assembly described above may also include the heating element that will be described in detail further below.

The present optical assembly is advantageously configured as one-single unit that may include said optical contamination detection system and said heating element that may be mounted, for example, to a camera arrangement. Said one-single unit, an optical assembly in a camera arrangement can be efficiently cleaned. As a result, optical contamination such as dirtiness, dust accumulation, mud splashes, water droplets, fog, condensation, frost, snow, ice sheets, etc. may be efficiently detected and removed by the same one-single unit defined by the present optical assembly and the camera arrangement may still produce images of good quality. This is particular advantageous in an Advanced Driver Assistance Systems (ADAS).

### BRIEF DESCRIPTION OF THE DRAWINGS

Non-limiting examples of the present disclosure will be described in the following, with reference to the appended drawings. In the drawings:
Figure 1 is a sectional elevation view of one example of a lens assembly provided with optical elements in which an electronics carrier comprises an electronic component arranged therebetween two optical elements;
Figure 2 is a sectional elevation view of a further example of a lens assembly in which an electronics carrier abuts an optical element;
Figure 3 is a sectional elevation view of a lens assembly showing an electronics carrier comprising two PCBs, wherein an electronic component includes a light source and a light receiver arranged on one PCB and the other PCB abuts an optical element;
Figure 4 is a sectional perspective view of the lens assembly in figure 3;
Figure 5 is a sectional elevation view of a lens assembly provided with a heating element in combination with an electrical connecting means configured to provide electric power;
Figure 6 is a schematic view of a lens assembly provided with a speckle detection system and a heating system.
Figure 7 is a plan view showing one example of a flexible electronics carrier;
Figure 8 is a perspective view of a flexible electronics carrier comprising two segments or PCBs;
Figure 9 is a plan view of a flexible electronics carrier;
Figure 10 is a schematic view of a lens assembly attached to an electronics carrier, the electronics carrier comprising an image sensor in optical communication with a lens body.
Figure 11 is a schematic view of an example of a camera arrangement provided with a speckle detection system and a heating system.

### DETAILED DESCRIPTION OF EXAMPLES

Examples of an optical assembly 10 are disclosed herein and shown in the figures of the drawings.

The optical assembly 10 comprises an optical body 100, a housing 200 adapted at least to receive the optical body 100, an electronics carrier 500, and an electronic component 300 coupled to the electronics carrier 500.

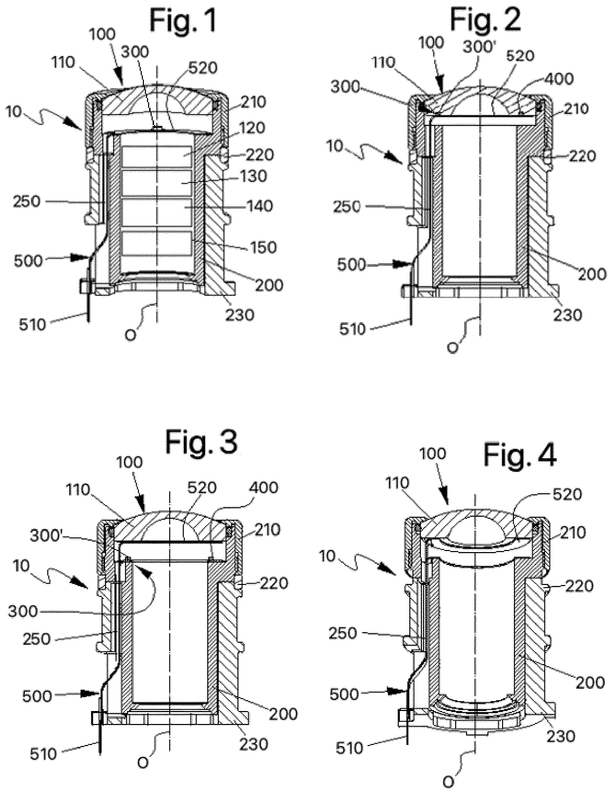

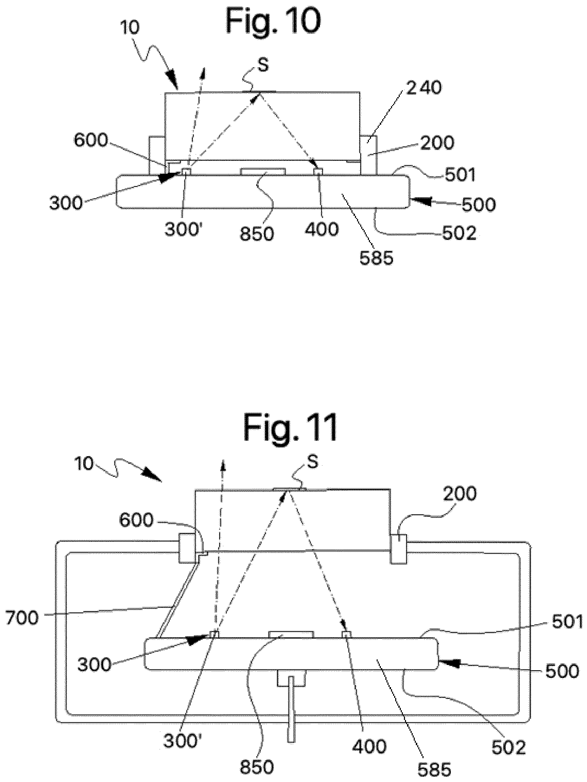

The present optical assembly 10 may be a lens assembly as shown in figures 1-6, or a camera arrangement as shown in figures 10-11. When the optical assembly 10 is the lens assembly, the housing 200 is a lens barrel and the optical body 100 is a lens body. When the optical assembly 10 is the camera arrangement, the housing 200 is a camera housing.

Figures 1-6 show the optical assembly 10 being, in particular, a lens assembly that may be, for example, part of a camera arrangement for a vehicle visual system. In use, the camera arrangement comprises an image sensor 850 so as to acquire a captured image. In operation, the lens assembly is configured and arranged for guiding light into said image sensor 850. For this purpose, the lens assembly and the image sensor 850 are optically aligned with each other along the optical axis O to be in proper optical communication, as it will be described below.

Below is a detailed description of the main parts of the optical assembly 10, e.g., the lens assembly and the camera arrangement, as well as main steps of related methods.

### Electronics carrier

Figures 1-6 show the electronics carrier 500 is arranged within the optical assembly 10. In particular, the optical assembly 10 is the lens assembly. Particularly, the electronics carrier 500 is arranged within the housing 200. More in particular, the housing 200 is the lens barrel that will be described further below. This is, at least a portion of the electronics carrier 500 is arranged inside the lens barrel.

Figures 10-11 show the electronics carrier 500 is arranged within the camera arrangement. Particularly, as shown in figure 11, the electronics carrier 500 comprises an imager printed circuit board including the image sensor 850 and being arranged within the housing 900, e.g., enclosed by the camera housing. For example, the camera housing comprises, in turn, a first housing part, e.g., front housing, and a second housing part, e.g., back housing, adapted for being attached together. In use, the camera housing defines an interior space so as to receive at least the imager printed circuit board.

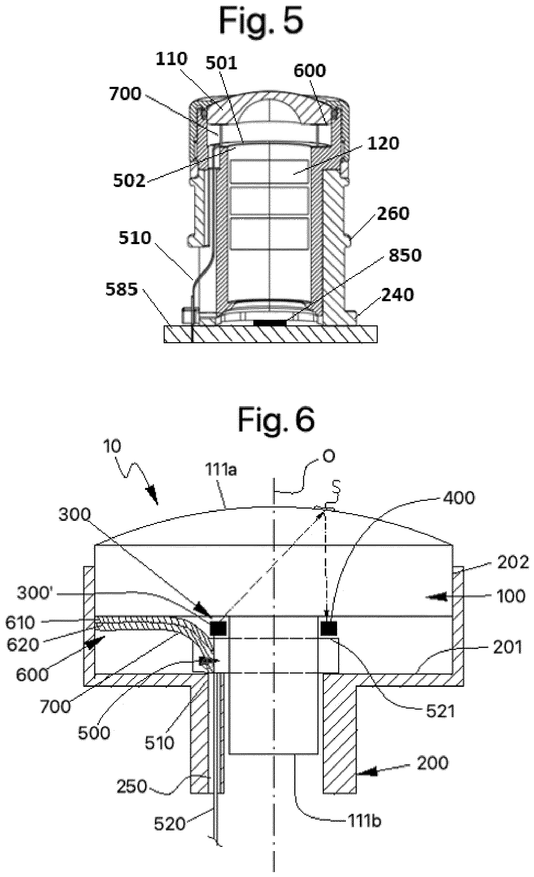

As shown in figures 1-6, the electronics carrier 500 is arranged between a top end 111a and bottom end 111b of the optical body 100, e.g., the lens body (see figure 6 for the reference signs 111a and 111b). In particular, a portion of the electronics carrier 500 is arranged between a first optical element 110 and a second optical element 120 that will be also described below.

As shown, the electronics carrier 500 includes two main surfaces 501, 502 opposed to each other (see figure 5 for the reference signs 501, 502). In particular, the electronics carrier 500 includes a first main surface 501 and a second main surface 502 connected with each other through an edge. The second main surface 502 of the electronics carrier 500 is attached to, arranged abutting, seated, or positioned on a first coupling surface 201 of the housing 200 that will be also described below. The first main surface 501, as described below, is adapted for receiving the electronics component 300.

In the example herein disclosed, the electronics carrier 500 is a flexible electronics carrier 500 particularly made of a malleable material such that it can be easily bent.

The electronics carrier 500 comprises a first portion 510 extending in a direction substantially parallel to the optical axis O and a second portion 520 at least partially contained in a plane that is substantially perpendicular to the optical axis O. In the example shown, the electronics carrier 500 is up to 3 mm thick, so that said second portion 520 of the electronics carrier 500 may be considered as being contained in said plane substantially perpendicular to the optical axis O.

In examples, the second portion 520 of the electronics carrier 500 is arranged between the first optical element 110 and the second optical element 120 of the lens body 100 as it will be described further below.

Figures 3 and 4 show an electronics carrier 500, particularly a second portion 520, comprising a first printed circuit board and a second printed circuit board. Further substrates having electronics are also possible. The first and second printed circuit boards may be parallel to each other. The first PCB comprises the electronic component 300. The second PCB directly contacts the first optical element 110. Further, the second PCB is arranged for being electrically connected to the heating element 600. Also, the second PCB is further configured to receive electric power from a power source that will be described further below.

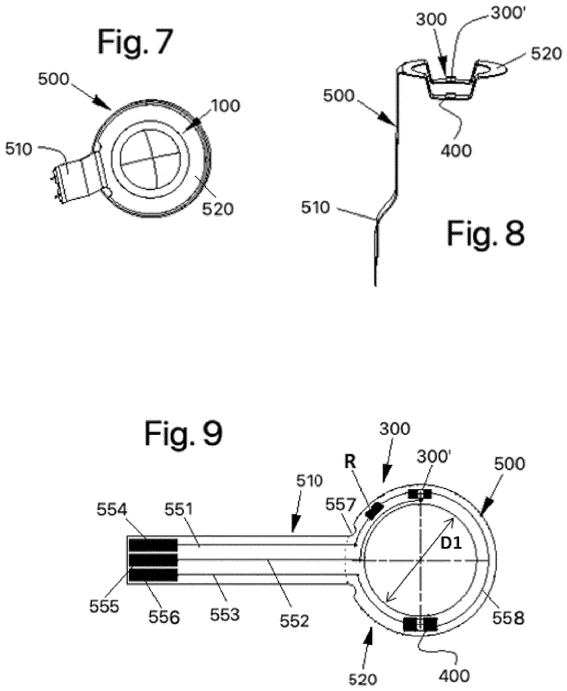

As shown in figures 7-9, the second portion 520 of the electronics carrier 500 includes a planar ring-shape geometry. In this way, the electronics carrier 500 is arranged within the lens assembly at least partially extending around the optical body 100, e.g., the lens body, and between opposite ends 111a, 111b of the optical body 100. In particular, at least said second portion 520 of the electronics carrier 500 extends at least partially around a second diameter of the optical body 100, e.g., lens body.

The electronics carrier 500 shown in figure 8 comprises the second portion 520 provided with a plurality of segments. The plurality of segments includes a first and a second segment spaced apart from each other and joined together, for example, through a third segment. Both first and second segments are substantially perpendicular to the optical axis O. Further, the first segment is arranged for carrying the electronic component 300, wherein the second segment is arranged for being electrically connected to the heating element 600. In use, the first segment is closer to the image sensor 850 than the second segment. The second segment is closer to the first optical element 110 than the first segment.

Figure 9 shows the electronics carrier 500 including three electric tracks 551, 552, 553 for supplying electric power to the electronic component 300. Furthermore, if the heating element 600 is provided, the electronics carrier 500 is further configured to supply electric power to the heating element 600 as described below. In any case, the electronics carrier 500 is further configured to receive electric power by the power source.

As shown in figure 9, the electronics carrier 500, particularly the first portion 510, comprises three conductive pads 554, 555, 556. Said three conductive pads 554, 555, 556 are located at or near an end of the first portion 510. The conductive pads 554, 555, 556 are depositions of electrically conductive material such as copper, particularly, on the first main surface 501. In examples, the three conductive pads 554, 555, 556 are between 4 and 6 mm long, 1 and 1.5 wide, and 0.1 and 0.2 thick. The first conductive pad 554 is electrically connected to the first electric track 551. The second conductive pad 555 is electrically connected to the second electric track 552. The third conductive pad 556 is electrically connected to the third electric track 553. The second conductive pad 555 is the ground (GND). The conductive pads 554, 555, 556 are electrically connected to the power source.

As shown in figure 9, the electronics carrier 500, particularly the second portion 520, comprises a resistor device R. In particular, the resistor device R is located on the first main surface 501. The resistor device R is connected at one end to the first electric track 551 and at the other end to the light source 300'. The resistor device R is configured to limit the electric current flowing through the light source 300'. The light source 300' comprises a diode being, for example, a LED (light-emitting diode) device. The resistor device R has an electrical resistance of between 50 to 800 ohms, particularly, 100 to 400 ohms. The light source 300', e.g., the LED device, is electrically connected to the resistor device R, the second electric track 552, and the light receiver 400. The electrical connection to the light receiver 400 is made through a further electrical track 558. This is, the further electrical track 558 is configured to electrically connect the light source 300' and the light receiver 400 to each other. The light receiver 400 is further electrically connected to the third electric track 553. The third electric track 553 is electrically connected to third conductive pad 556. Furthermore, the described electric circuit operates with pulsed current. This is, pulsed current circulates on the electric tracks. In examples, the electrical power is of between 0.2 and 5 watts, particularly, 0.5-1 watts.

Figure 9 shows the electronics carrier 500, particularly the second portion 520, is provided with a through opening D1 adapted for being traversed by a portion of the lens body. In particular, the through opening D1 is equal to or greater than the portion of the lens body that is arranged partially through said through opening D1. In examples, the through opening D1 is circular. The through opening D1 has a diameter which is equal to or greater than the above-mentioned second diameter of the optical body 100, e.g., lens body. It allows a portion, e.g., an end, of the lens body to pass through the through opening D1 of the electronics carrier 500. In particular, the diameter of the through opening D1 is above 8mm, particularly, above 10mm, more in particular, between 10mm and 30mm. As shown, the through opening D1 is arranged between a portion of the further electric track 558 and the first portion 510 of the electronics carrier 500. Furthermore, the electric track connecting the light source 300' and the light receiver 400, e.g., the further electric track 558, is disposed curved. In particular, the further electric track 558 is at least partially arranged around the lens body. The radius of curvature of the electric track 58 is greater than the radius of the second diameter of the lens body.

Figure 9 additionally shows that the electronics carrier 500 further comprises notches 557 between the first and second portions 510, 520. This facilitates the bending of the second portion 520 with respect to the first portion 510, for example, about 90°.

There are several possible placement options for the light source 300' and the light receiver 400, for example opposite each other as shown in figure 9. Different placement options are possible, but it is preferred not next to each other. In particular, the light source 300' and the light receiver 400 are angularly separated by more than 45°.

The electronics carrier 500 may be made of, for example, FR4, especially in case of multilayer board. However other suitable materials with sufficient strength and water resistance may be used, such as, for example, FR2, polyamide, CEM 1, CEM 3 and other paper-based materials with good electrical insulating properties capable of providing at least one electric path along which current is guided.

### Optical body

In the shown examples disclosed in figures 1-6, the optical body 100 is provided comprising two or more optical elements 110, 120, 130, 140, 150. As explained, the optical body 100 is the lens body when the optical assembly is the lens assembly. Each of said optical elements 110, 120, 130, 140, 150 is a lens. The electronic component 300 is arranged therebetween two of the optical elements 110, 120, 130, 140, 150. Said optical elements 110, 120, 130, 140, 150 may or may not be in direct contact with each other. For example, the optical elements 110, 120, 130, 140, 150 may be arranged spaced apart a predetermined distance along the optical axis O.

In the non-limiting example shown in figure 1, the optical body 100 comprises five optical elements 110, 120, 130, 140, 150, arranged one after the other along the direction of the above-mentioned optical axis O. Other different number of optical elements 110, 120, 130, 140, 150 of course may be provided. The plurality of optical elements 110, 120, 130, 140, 150 are received within the housing 200 that will be described below. In use, the first optical element 110 is the optical element arranged furthest from the image sensor 850. Also, the first optical element 110 is arranged closest to the exterior environment. In fact, the first optical element 110 may comprise an exterior surface. Furthermore, the second optical element 120 is arranged between the first optical element 110 and the electronics carrier 500 along the optical axis O. A last optical element 150 is arranged closest to the image sensor 850.

In use, the optical body 100 is in optical communication with the image sensor 850 along the optical axis O so as to acquire a captured image from an exterior field of view of a motor vehicle extending at least outside the vehicle. Alignment of the optical elements 110, 120, 130, 140, 150 along the optical axis O allows light to be guided from one optical element to another so as to reach the image sensor 850 properly.

The lens body 100 is substantially circular in shape, i.e., the optical body 100 is substantially circular in cross-section. However, other shapes may be possible. The plurality of optical elements 110, 120, 130, 140, 150 may be coupled to an inner surface of the housing 200.

As stated above in connection with the electronics carrier 500, the lens body 100 has a top end 111a and a and bottom end 111b. As illustrated in figure 6, the optical body 100, e.g., the lens body, extends from said top and bottom ends 111a, 111b. The top end 111a of the optical body 100 corresponds to a top end of the first optical element 110. The bottom end 111b of the lens body 100 corresponds to a bottom end of the last optical element 150.

Figure 6 illustrates the optical body 100, e.g., lens body, including a peripheral surface connecting the top end 111a and the bottom end 111b. Said peripheral surface has a first diameter located at or near the top end 111a and a second diameter located closer to the bottom end 111b than the first diameter and at least between the top end 111a and the bottom end 111b. The first diameter is greater than the second diameter. The lens barrel 200 to be described below may be at least partially arranged around the second diameter.

### Housing

The housing 200 is provided extending longitudinally along the optical axis O. Figures 1-6 show the housing 200 is the lens barrel. The lens barrel may be a single piece, such as for example a plastic or aluminum injection molded part or be made of a number of parts. For example, the lens barrel 200 may include a number of housing elements 210, 220, 230 as illustrated in figures 1-5 of the drawings.

The lens barrel 200 is configured for receiving a number of optical elements 110, 120, 130, 140, 150, as described above, arranged one after the other along the direction of said optical axis O. In the example shown, the lens barrel 200 is a tube-shaped member inside of which the plurality of optical elements 110, 120, 130, 140, 150 are received suitably aligned as stated above. The lens barrel 200 may include mounting features sized and configured to engage with and position a plurality of internal optical elements such as one or more fixed lenses, shutter elements, cover elements and the like.

As illustrated in figure 6, the lens barrel 200 comprises a first coupling surface 201 that is arranged substantially perpendicular to the optical axis O. The first coupling surface 201 is intended for receiving the electronics carrier 500, in particular, for receiving the second main surface 502 of the electronics carrier 500. The electronics carrier 500 may be attached to, seated in, or positioned on the first coupling surface 201 of the housing 200. As a result, the second main surface 502 of electronics carrier 500 is in direct contact to the first coupling surface 201 of the lens barrel 200.

Alternatively, it is possible within the meaning of the present invention that the lens body comprises a cutout or groove for receiving the electronics component 300 as shown in figure 2. In particular, at least a portion of the light source 300' and/or a portion of the light receiver 400 may be arranged inside the lens body 100. More in particular, the cutout is located on a bottom surface of the first optical element 110. In this particular example, the electronics carrier 500 abuts the first optical element 110.

As shown in figures 1-6, the lens barrel also comprises attaching means for fixing the electronics carrier 500 in the lens barrel. In examples, the attaching means comprises adhesive such as glue. Other attaching means are of course possible such as welding. Said attaching means is provided between the second main surface 502 of the electronics carrier 500 and the first coupling surface 201 of the lens barrel 200. As a result, the second main surface 502 of the electronics carrier 500 is in direct contact to the attaching means for suitably fixing the electronics carrier 500 and the lens barrel 200 to each other.

The lens barrel further comprises a second coupling surface 202 for coupling, e.g., attaching the lens body and the lens barrel to each other as shown in figures 1-6.

As shown, the lens barrel 200 has a first end and second end. The lens barrel 200 extends longitudinally along the optical axis O between said first and second ends. The lens barrel 200 comprises a bottom surface disposed at or near the second end, and one or more sidewalls including an inner surface. A space is defined in an interior of the lens barrel 200.

A passageway 250 is formed in the lens barrel for receiving therein at least the first portion 510 of the electronics carrier 500. The passageway 250 is arranged extending through a lateral side of the lens barrel.

Figure 5 shows the housing 200, e.g., the lens barrel, comprising a flange 260 extending outward with respect to the optical axis O for being attached to the camera housing (not shown). In use, the flange 260 is arranged within the camera housing.

As shown in figures 5 and 10, the housing 200, e.g., the lens barrel, may further comprise a positioning portion 240 configured to attach the lens barrel and the electronics carrier 500, e.g., an imager PCB 585, to each other such that, in use, the image sensor 850 and the optical body 100, e.g., the lens body, are in optical communication. The image sensor 850 is coupled to the imager PCB 585. The electronic component 300 may be coupled to the imager PCB 585 as shown in figures 5 and 10, or alternatively, to the above-mentioned second portion 520 of the electronics carrier 500 (see figures 1, 2,3, 6).

When the optical assembly is the camera arrangement, the housing 200 is the camera housing as illustrated in figure 11. The camera housing 200 encloses at least a portion of the optical body 100, the electronics carrier 500, and the electronic component 300. Further, the camera housing comprises the first coupling surface for receiving the electronics carrier 500 (not shown). The camera arrangement 100 further comprises an attaching means for positioning the electronics carrier 500 in the camera housing 200. Where attaching means are provided, they are at least one of: adhesive means, welding means, fastening means, or a clamping pressure means. As a result, the electronics carrier 500 is in direct contact to the attaching means for suitably fixing the electronics carrier 500 and the camera housing to each other. The fastening means are, for example, screws for attaching the electronics carrier 500 to the camera housing (not shown). In particular, the screws are adapted for attaching the electronics carrier 500 to the front camera housing. The clamping pressure means comprises an inner surface of the camera housing for sandwiching the electronics carrier 500. Particularly, when the front camera housing and the back camera housing are attached to each other, the front camera housing contacts at least a portion of the first main surface 501 and the back camera housing contacts at least a portion of the second main surface 502 of the electronics carrier, in use, the electronics carrier 500 being sandwiched there between said front and back camera housings.

### Electronic component

The electronic component 300 comprises, for example, at least one of one or more light sources 300', and one or more light receivers 400. The light source 300' is configured to emit light to the optical body 100. The light source 300' is a device suitable for emitting light. Light sources 300' may be also referred herein to as light emitters. The light source 300' comprises a LED (light-emitting diode) device. Within the meaning of the present disclosure, light refers to one of more light beams. Further, the light receiver 400 is configured to receive light reflected from the optical body 100. The light receiver 400 is a device suitable for receiving light reflected by the optical body 100, that is, light receivers 400 may be sensors for capturing photons.

In particular, the electronic component 300 comprises both one or more light sources 300' and one or more light receivers 400. Alternatively, according to a non-shown example, the electronic component 300 may comprise a sensor, for example a temperature sensor to sense the temperature of a portion of the optical body, e.g., the first optical element 101.

As shown in figures 1-6, the electronic component 300 is particularly arranged between the first main surface 501 of the electronics carrier 500 and the top end 111a of the optical body 100. More specifically, the light sources 300' and the light receivers 400 are placed between the exterior surface of the first optical element 110 and the first main surface 501 of the electronics carrier 500. In use, the light sources 300' and the light receivers 400 are electrically connected to the electronics carrier 500. The exterior surface of the optical body 100 may be also referred to as front surface of the optical body 100.

It may be preferred that the electronic component 300 includes a relatively large number of light sources 300' and light receivers 400. As a result, the signal-to-noise ratio (SNR) is desirably increased. Also, false positives in the determination of optical contamination by the system may be avoided.

The light sources 300' and the light receivers 400 are part of an optical contamination detection system. The optical assembly 10 of the present invention includes said optical contamination detection system. The electronic component 300 advantageously provides the optical assembly 10 with an efficient optical contamination detection function. In use, light from the one or more light sources 300' of the electronic component 300 is reflected by an exterior surface of the optical body 100 when optical contamination S is present on the surface of the optical body 100, as illustrated in figures 10, 11. Light reflected by the optical body 100 is received by the one or more light receivers 400 of the electronic component 300 such that said optical contamination S on the exterior surface of the optical body 100 can be efficiently detected. Exterior surface means herein a surface in the optical body 100 that is in contact with the exterior environment. The exterior surface is where optical contamination S to be detected and removed is deposited.

The at least one light source 300' may comprise a coupling surface for attaching to the electronics carrier 500, in particular to the first main surface 501 of the electronics carrier 500.

Said at least one light source 300' may be configured to emit light at a wavelength below 400 nm or above 780 nm, that is, the light source may be configured to generate light at a wavelength out of the region of the visible light such as infrared light. More in particular, the light source 300' may be configured to emit light at a wavelength of 760-800 nm, or at a wavelength of 920-960 nm, or at a wavelength of 1110-1150 nm, or at a wavelength of 1380-1420 nm, or even at a wavelength of 1880-1920 nm.

The light source 300' may comprise one or more light emitting diodes (LEDs) configured to emit light at one of the following bandwidths: ± 40 nm, ± 20 nm or ± 10 nm. In preferred examples, the bandwidth may be ± 15 nm. The at least one light source 300' may comprise other suitable light sources.

Emitting light in the electromagnetic spectrum that is visible to the human eye such as at wavelengths between 300 nm and 780 nm, may interfere with the image that is being captured. The light sources 300' may avoid the emission of light centered on such wavelengths. Providing light source 300', such as light emitting diodes, with an emission wavelength centered on atmosphere absorption bands, the electromagnetic radiation coming from sunlight may be absorbed by the atmosphere.

At the wavelengths stated above, the atmosphere absorbs much of the energy coming from the sun. The sunlight reaching the light receivers 400 may thus be reduced. As a result, all or almost all of the electromagnetic radiation received by the light receivers 400 will be related to the light emitted by the light emitting diodes and scattered by optical contamination S on the optical body 100. False positives in the detection of optical contamination S may thus be avoided and the detection of optical contamination S in a surface of the optical body 100 may be improved. Also, operation of the light receivers 400 on the above wavelengths by may reduce the ambient light reaching the light receivers 400.

The at least one light receiver 400 may comprise a coupling surface for attaching to the electronics carrier 500, in particular to the first main surface 501 of the electronics carrier 500.

The light receiver 400 comprises a photo sensor. This is, the light receivers 400 may include at least one photodiode or at least one phototransistor. In particular, the light receiver 400 may comprise broadband detectors including ultra-violet detectors configured to detect light at a wavelength under 400 nm and/or infrared detectors configured to operate at a wavelength over 700 nm, for example, depending on the light source 300' used. The broadband detectors may be configured to detect light wavelengths of 200-1100 nm. For broadband detectors the most common and affordable material may be silicon, however some other material may be considered. For broadband detectors configured to detect wavelengths higher than 1100nm, the chosen material may be Indium gallium arsenide (InGaAs).

An ambient light detector may be also provided configured to sense light outside the housing 200. Reflected light may be received by light receivers 400 together with ambient light. The signal produced by the sensed ambient light may be subtracted from the signal produced from the reflected light comprising emitted light and ambient light such that only the reflected light received by the light receiver 400 is counted for, and thus noise is removed from the signal. The signal-to-noise ratio (SNR) may thus be increased.

A lock-in amplifier may be also provided. The lock-in amplifier is capable of extracting a signal with a known carrier wave from a noisy environment. The lock-in amplifier may perform a multiplication of its input with a reference signal, and then it may apply an adjustable low-pass filter to the result. This may be used to mitigate the effect of ambient light. For example, when the light sources 300' do not emit light, the light received by the light receivers 400 may only be the ambient light. Said signal may be set up as a reference signal. In this way, said reference signal itself may be used to modulate a signal corresponding to the light received by the light receivers 400 when light is reflected from the optical contamination S, as illustrated in figures 10, 11, 12. When the light sources 300' emit light, the lock-in amplifier may extract a useful signal of the signal corresponding to the light received by the light receivers 400 using said reference signal. Hence any ambient light is subtracted and removed from the received light.

### Heating element

The optical assembly 10 may further comprise a heating element 600 as stated above. The heating element 600 includes a conductive body for resistive heating of at least a portion of the optical body 100 as an electric current flows through. The conductive body includes an optically transparent coating 610 arranged on the optical body 100 with an optically transparent conductive layer 620 as illustrated in figure 6. It is to be noted that the optically transparent coating 610 may be a surface coating applied to the optical body 100 or it may be formed integral therewith. Alternatively, the optically transparent coating 610 may be provided close to the optical body 100 but not in contact with it. In preferred examples, the optically transparent coating 610 is in direct contact with at least one portion of the optical body 100.

The optically transparent coating 610 is suitable for resistive heating of at least one portion of the optical body 100 as an electric current flows through. Thus, as an electric current flows through the heating element 600, optical contamination S such as dirtiness, dust accumulation, mud splashes, water droplets, frost, fog, condensation, snow, ice sheets, etc. that may be attached to an exterior surface of the optical body 100 can be efficiently removed from the optical body 100.

The optically transparent coating 610 may be of a homogeneous and/or continuous or non-homogeneous and/or discontinuous nature depending on optical and heating requirements. The optically transparent coating 610 further comprises an optically transparent conductive layer 620, as stated above, which may be also of a homogeneous and/or continuous or non-homogeneous and/or discontinuous nature depending on optical and heating requirements.

The optically transparent layer 620 may be directly applied to any surface of the first optical element 110 of the lens body 100. An optically transparent back layer may be provided to eliminate or to at least reduce reflections from the surface of the optical body 100 due to heating action of current flowing therethrough.

In examples, the heating element 600 is arranged between the electronic component 300 and the top end of the optical body 100 including the top end of the optical body 100. In particular, the heating element 600 is arranged between the first optical element 110 and the electronic component 300 including the first optical element 110. In turn, the electronic component 300 may be arranged between the first optical element 110 and the electronics carrier 500, in particular the first main surface 501 of the electronics carrier 500, as stated above.

Figures 5 and 6 show the optical assembly 10 may further comprise an electrical connecting means 700 for providing electric power to the heating element 600. In this way, the heating element 600 is electrically connected to the electronics carrier 500. This is, the electrical connecting means 700 is adapted for electrically connecting the electronics carrier 500 and the heating element 600.

As shown, the electrical connecting means 700 is a flexible element or a biasing element such as a metallic spring. It is adapted to be deformed at least in the direction of the optical axis O. It allows to compensate manufacturing and assembly tolerances along the optical axis O. In examples, the electrical connecting means 700 is a conductive flexible material stacked between the first optical element 110 and the electronics carrier 500. Alternatively, the electrical connection means 700 is a conductive gasket arranged on top of the electronics carrier 500 and abutting the first optical element 110, for example, on a bottom surface thereof. The electronics carrier 500 may be electrically connected to a power source that will be described below.

Attaching means may be provided for attaching the electrical connecting means 700 to the optically transparent coating 610 of the heating element 600. In use, the electrical connecting means 700 may be electrically connected to the optically transparent conductive layer 620 of the heating element 600. The attaching means may comprise, for example, a conductive adhesive means that may include a transparent conductive glue.

In examples, the optically transparent conductive layer 620 of the optically transparent coating 610 comprises at least aluminum-doped zinc oxide (AZO). In one example, the optically transparent coating 610 has an electrical resistance of 100-1500 ohms and is applied to a curved surface of the first optical element 110, providing thus a good tradeoff between a fast heating process and safety. The optically transparent coating 610 has a thickness of between 50nm and 1000nm. The thickness of the transparent conductive AZO layer 630 has a significant impact on the Joule effect for efficiently heating of the optical body 100. The thickness of the AZO layer 630 of the optically transparent coating 310 is large enough for a low electrical resistance and short heating time of the optical body 100. On the other hand, the thickness of the transparent conductive AZO layer 330 is small enough for low reflectance of the optical body 100 for good image quality and safety.

The optically transparent coating 610 is critically important for a good compromise between the greatest optical transparency for enhanced image acquisition and optimum electrical conductivity for lens heating. As a result, enough high power can be supplied suitably to heat up the optical body 100 quickly, for example to melt ice adhered thereto, but not too high (e.g., below 60°C) in order not to compromise safety for avoiding burns and damages if someone touches the optical assembly. A good balance between light transmission (low reflectance), heating speed, and safety is provided.

An electric current is supplied to the optically transparent coating 610 by means of the above-mentioned electrical connecting means 700 through a power source that will be described below.

### Power source

In the example disclosed herein, the power source may be a suitable 10-16 V power source, particularly, 12-14 V. In examples, the power source is connected to the optical assembly 10. In other examples, the power sources may be part of the optical assembly 10 (not shown). This is, the power source may be part of or connected to the lens assembly, or alternatively, part of or connected to the camera arrangement being not part, e.g., arranged out of the lens assembly. In particular, the power source may be part of or be connected to the imager PCB 585. It may be possible that power source is not a part of the camera arrangement. In use, the power source may be arranged inside or outside the camera arrangement as long as the electric power is provided as required. The power source may be arranged out of the camera arrangement such as for example inside a motor vehicle body.

In examples, the camera arrangement may use a camera cable or power over coaxial (PoC) configured for simultaneous transmission of power and high-resolution analog-video signal and OSD control signal over a single coaxial cable.

### Camera arrangement

Figures 10-11 show the optical assembly 10 is a camera arrangement for a vehicle visual system. The camera arrangement is an image capturing device configured to acquire images such as photos, videos, etc. of an environment of the vehicle. In some examples, the camera arrangement may be a detection-vision camera to be mounted in a vehicle for detecting obstacles, a camera configured to monitor other systems of the vehicle, a driving assistance camera, rear-view mirror system, etc. Such vision systems may be suitable for vehicles of any type and movable on any medium, such as e.g., roadways, railways, boats, airplanes, cars, etc.

The camera arrangement may be part of a visual system that includes a display device and an electronic control unit (ECU) electrically connected to the camera arrangement. The ECU may be configured to generate an image signal to the display device for displaying to a user a displayed image derived at least in part from the captured image.

The camera arrangement is any suitable type of image capture device. It may be a camera arrangement of the type commonly referred to as a digital camera, or it may be a camera arrangement of the type commonly referred to as an analogue camera. Such digital and analogue cameras may be, for example, CMOS cameras, charged coupled device (CCD) cameras and the like. A typical CMOS digital camera may be a CMOS camera producing image frames of 640 pixels in the direction and 480 pixels in the Y direction, at a rate of, for example, fifteen image frames per second.

The camera arrangement is configured to capture image data and it may provide the image data to a further processing device or control unit for processing the image data. In particular, the image data may be provided in form of image frames. The camera arrangement may capture image data in form of frames having a predetermined resolution. In examples, camera may capture frames in regular time intervals. The images acquired are a video feed in real time, this is, with very little delay between acquired (e.g., captured) and displayed. For example, the framerate is above 15 frames per second (fps), particularly, equal to or above 30 fps, more in particular, equal to or above 60 fps. Higher resolution is not ruled out, for example, including an image sensor with a resolution of above 1 Megapixel, particularly, equal to or above 3 Megapixel.

In case of a passenger vehicle, the camera arrangement may be mounted in any desired location on the vehicle, for example, the camera arrangement may be mounted to the rear of the motor vehicle for capturing images to the rear of the motor vehicle for displaying on a visual display screen, for example, a dashboard mounted visual display screen for presenting images acquired (e.g., captured) by the camera arrangement to a driver of the vehicle. Such rearward images may be downwardly looking plan view images of an area to the rear of the motor vehicle for use in assisting the driver to carry out reverse maneuvering of the vehicle in a confined space, or the rearward images may be images looking in a generally rearward direction from the vehicle (e.g., CMS - Camera Monitoring System, IRMS).

In examples, the camera arrangement may be mounted on a side mirror of the motor vehicle for capturing a downward looking plan view image of the ground adjacent the side of the vehicle for display on the display screen, and also for assisting the driver in carrying out maneuvering of the vehicle in a confined space, for example, for parking, and in particular, parking the vehicle parallel to a kerb. In some other examples, the camera arrangement may also be located to the front of the vehicle for capturing a downward looking plan view of the ground adjacent the front of the vehicle, or for capturing an image looking in a generally forward direction from the vehicle. The mounting and operation of such cameras is well known to those skilled in the art.

The camera arrangement comprises a lens assembly, an electronics carrier 500, and an image sensor or imager 850 coupled to the electronics carrier 500 and in optical communication with the lens assembly, that is, the image sensor 850 is optically aligned with optical body 100 along the optical axis O. The camera arrangement further comprises an electronic component 300 coupled to the electronics carrier 500. Further, the electronics carrier 500 is enclosed within the camera housing.

### Method of making an optical assembly

A method of making an optical assembly 10 is also disclosed herein. The method comprises providing a housing 200 adapted to receive an optical body 100 that defines an optical axis O and coupling an electronic component 300 to an electronics carrier 500. At least one portion of said electronics carrier 500 is arranged inside the housing 200.

The electronic component 300 comprises at least one of: one or more light sources 300' to emit light towards the optical body 100 with the optical body 100 configured to reflect light from the light source 300' when optical contamination S is located on the surface of the optical body 100; and one or more light receivers 400 to receive the light reflected by the optical body 100 such that optical contamination S on an exterior surface of the optical body 100 is detected.

The method further comprises providing the electronics carrier 500 behind at least one optical element 110, 120, 130, 140, 150 of the optical body 100 along the optical axis O.

The method may further comprise inserting at least one portion of the electronics carrier 500 inside the housing 200 such that the electronics carrier 500 and the electronic component 300 are arranged between two optical elements 110, 120, 130, 140, 150 of the optical body 100.

### Method of detecting optical contamination on an optical assembly

A method of detecting optical contamination S such as dirtiness, dust accumulation, mud splashes, water droplets, frost, fog, condensation, snow, ice sheets, etc. on an optical assembly 10 is also disclosed herein.

The method comprises the steps of emitting, by one or more light source 300', light towards an optical body 100, and receiving, by one or more light receiver 400, light reflected from the optical body 100 when optical contamination S is located on an exterior surface of the optical body 100.

For this purpose, said optical body 100 is configured to reflect light from said at least one light source 300' when optical contamination S is located on a surface of the optical body 100.

The method further comprises detecting optical contamination S located on a surface of the optical body 100. It may be based on the amount of reflected light detected by the one or more light receiver 400.

The method preferably further comprises acquiring a video feed from an exterior field of view of a vehicle extending at least outside the vehicle.

The method preferably further comprises generating a heating instruction, at least when optical contamination S has been detected, and providing electric current to a heating element 600 that is optically transparent and electrically conductive for resistive heating of at least a portion of the optical body 100 as an electric current flows through. Said heating element 600 is arranged between a portion of the optical body 100 and at least one of the light source 300' and the light receiver 400.

For reasons of completeness, various aspects of the present disclosure are set out in the following numbered clauses:
Clause 1: An optical assembly (10) comprising:
   - an optical body (100);
   - a housing (200) adapted at least to receive the optical body (100);
      wherein, in use, the optical body (100) is intended to be in optical communication with an image sensor (850) so as to acquire a captured image from an exterior field of view of a vehicle extending at least outside the vehicle;
   - an electronics carrier (500); and
   - an electronic component (300) coupled to the electronics carrier (500);

   wherein the electronic component (300) comprises at least one of:
      - one or more light sources (300') configured to emit light to the optical body (100), and
      - one or more light receivers (400) configured to receive light reflected from the optical body (100) when optical contamination (S) is present on an exterior surface of the optical body (100); and
   wherein the electronic component (300) and at least a portion of the electronics carrier (500) are arranged within the housing (200);
   wherein the electronic component (300) is further arranged between a main surface (501) of the electronics carrier (500) and a portion of the optical body (100);
   wherein the housing (200) comprises a first coupling surface (201) for receiving at least one of:
      - the electronics carrier (500), and
      - an attaching means for fixing the electronics carrier (500) in the housing (200);
      and
   preferably, the optical assembly (10) is a lens assembly or a camera arrangement.
Clause 2: An optical assembly (10) comprising:
   - an optical body (100);
   - a housing (200) adapted at least to receive the optical body (100);
   - an electronics carrier (500); and
   - an electronic component (300) coupled to the electronics carrier (500);

   wherein the electronic component (300) comprises at least one of:
      - one or more light sources (300') configured to emit light to the optical body (100), the optical body (100) being configured to reflect light from the light sources (300) when optical contamination (S) is located on an exterior surface of the optical body; and
      - one or more light receivers (400) configured to receive light reflected from the optical body (100) such that optical contamination (S) on the exterior surface of the optical body is detected;
   preferably, the light source (300') is configured to emit light at a wavelength below 400 nm or above 780 nm;
   preferably, the electronic component (300) is arranged between a main surface (521) of the electronics carrier (500) and a portion of the optical body (100); and
   preferably, one or more light sources (300') comprises a coupling surface for attaching the one or more light sources (300') to the electronics carrier (500) and / or one or more light receivers (400) comprises a coupling surface for attaching the one or more light receivers (400) to the electronics carrier (500).
Clause 3: An optical assembly (10) comprising:
   - an optical body (100) defining an optical axis (O);
   - a housing (200) adapted to receive the optical body (100);
   - an electronics carrier (500); and
   - an electronic component (300) coupled to the electronics carrier (500);

   wherein the electronics carrier (500) is arranged within the optical assembly (10) at least partially extending around the optical body (100) and between opposite ends (111a, 111b) of the optical body (100);
   preferably, the optical assembly (10) is a lens assembly for a camera arrangement;
   preferably, the electronics carrier (500) is a flexible electronics carrier comprising a first portion (510) and a second portion (520), wherein the first portion (510) extends in a direction substantially parallel to the optical axis (O), and the second portion (520) is at least partially contained in a plane that is substantially perpendicular to the optical axis (O); and
   preferably, the housing (200) comprises a passageway (250) so as to receive at least a portion of the first portion (510) of the electronics carrier.
Clause 4: An optical assembly (10) comprising:
   - an optical body (100);
   - a housing (200) adapted at least to receive the optical body (100);
   - an electronics carrier (500); and
   - an electronic component (300) coupled to the electronics carrier (500);

   wherein it further comprises a heating element (600) comprising an electrically conductive body for resistive heating of at least one portion of the optical body (100) as an electric current flows through;
   wherein it further comprises an electrical connecting means (700) configured to electrically connect the electronics carrier (500) and the heating element (600); and
   preferably, the heating element (600) being optically transparent and electrically conductive and arranged between the optical body (100) and the electronic component (300), preferably applied to a curved surface of the optical body (100).
Clause 5. The optical assembly (10) of any preceding clause, wherein the optical body (100) extends from a top end (111a) to a bottom end (111b), wherein the electronics carrier (500) is arranged between the top end (111a) and the bottom end (111b).
Clause 6. The optical assembly (10) of any preceding clause, wherein the electronics carrier (500) comprises a first main surface (501) and a second main surface (502) opposite to the first main surface (501), wherein the electronic component (300) is attached to the first main surface (501), preferably the optical assembly (10) is a lens assembly, the housing (200) is a lens barrel such that, in use, the second surface (502) is attached to the housing (200) through a coupling surface (201).
Clause 7. The optical assembly (10) of any the clauses 5 or 6, wherein the electronic component (300) is arranged between the top end (111a) of the optical body (10) and the first main surface (501) of the electronics carrier (500).
Clause 8. The optical assembly (10) of any preceding clause, wherein the housing (200) extends longitudinally along the optical axis (O) from a first end (233) to a second end, the housing (200) comprising a bottom surface disposed at or near the second end, and one or more sidewalls including an inner surface (201, 202), preferably, a space being formed in an interior of the housing (200).
Clause 9. The optical assembly (10) of any preceding clause, wherein the inner surface (201, 202) of the one or more sidewalls includes the first coupling surface for receiving at least one of the electronics carrier (500), and an attaching means for fixing the electronics carrier (500) in the housing (200).
Clause 10. The optical assembly (10) of any of the clauses 5-9, wherein the optical body (100) comprises one or more optical elements (110, 120, 130, 140, 150), preferably, a plurality of optical elements arranged one after the other along the optical axis (O), wherein the top end of the optical body (100) is a top end of the first optical element and the bottom end of the optical body (100) is a bottom end of the last optical element.
Clause 11. The optical assembly (10) of any of the clauses 8-10, wherein the top end of the optical body (100) is disposed in the space formed in the interior of the housing (200) at or near the first end (233) of the housing (200).
Clause 12. The optical assembly (10) of claim 10 or 11, wherein the electronic component (300) is arranged between the first optical element (110) and the second optical element (120).
Clause 13. The optical assembly (10) of any preceding clause, wherein the electronic component (300) comprises one or more light sources (300'), one or more light receivers (400), and a resistor device (R) electrically connected to one or more light sources (300') and having an electrical resistance of between 50 and 800 ohms, wherein the one or more light sources (300') is/are configured to emit light to the optical body (100), the optical body (100) being configured to reflect light from the light sources (300) when optical contamination (S) is located on an exterior surface of the optical body; and wherein the one or more light receivers (400) is/are configured to receive light reflected from the optical body (100) such that optical contamination (S) on the exterior surface of the optical body is detected,
   wherein at least an element of the electronic component (300) receives a pulsed current, and
   wherein the electronic component (300) operates with an electrical power of between 0.2 and 5 watts.
Clause 14. The optical assembly (10) of clauses 1,2, or 13, wherein at least one light source (300') comprises a coupling surface for attaching the light source (300') to the flexible electronics carrier (500); and/or at least one light receiver (400) comprises a coupling surface for attaching the light receiver to the flexible electronics carrier (500).
Clause 15. The optical assembly (10) of any of the clauses 4-14, wherein the heating element (600) is arranged between the top end (111a) of the optical body and the first main surface (501) of the electronics carrier.
Clause 16. The optical assembly (10) of any of the clauses 4-15, wherein the heating element is arranged between the electronic component (300) and the top end (111a) of the optical body. More preferably, the heating element is arranged between the one or more light sources (300') and the top end (111a) of the optical body.
Clause 17. The optical assembly (10) of any of the clauses 4-16, wherein the electrical connecting means (700) comprises an electrical conductive biasing means o flexible element, preferably being a metallic spring, electrically connected to the electric track (510) and an optically transparent conductive layer (620) of the heating element (600).
Clause 18. The optical assembly (10) of any of the clauses 4-17, wherein the electrical connecting means (700) is a part of or is attached to the electronics carrier (500), and/or comprises a flexible element or a biasing element.
Clause 19. The optical assembly (10) of any of the clauses 4-18, wherein it further comprises attaching means (710) for attaching the electrical connecting means (700) to an optically transparent coating (610) of the heating element (600) such that the electrical connecting means (700) are electrically connected to an optically transparent conductive layer (330) of the heating element (600).
Clause 20. The optical assembly (10) of clause 19, wherein the attaching means (710) comprises conductive adhesive means, preferably, transparent conductive glue.
Clause 21. The optical assembly (10) of any preceding clause, wherein the optical body (100) comprises a cutout so as to receive the one or more light sources (300') and/or the one or more light receiver (400) such that, in use, at least a portion of the light source (300') and/or one light receiver (400) is arranged inside the optical body (100).
Clause 22. The optical assembly (10) of any of the clauses 4-21, wherein the heating element is arranged between the one or more light sources (300') and the top end (111a) of the optical body.
Clause 23. The optical assembly (10) of any of the clauses 14-22, wherein the light sources (300') and/or the light receivers (400) is/are located inside a space formed between the optical body (100) and the first coupling surface (201).
Clause 24. The optical assembly (10) of any preceding clause, wherein it further comprises an imager PCB, and an image sensor (850) couple to thereof, wherein the housing (200) further comprises a positioning portion configured to attach the housing (200) and the imager PCB to each other such that, in use, the image sensor (850) and the optical body (100) are in optical communication.
Clause 25. The optical assembly (10) of any of the clauses 4-24, wherein the heating element (600) includes an optically transparent conductive layer (620) comprising at least aluminum-doped zinc oxide (AZO), preferably the optically transparent layer (620) has an electrical resistance of 100-1500 ohms.
Clause 26. The optical assembly (10) of any of the clauses 4-25, wherein the heating element (600) includes an optically transparent coating (610) comprising at least one optically transparent back layer (630) arranged between the optical body (100) and the optically transparent conductive layer (620).
Clause 27. The optical assembly (10) of clause 26, wherein the optically transparent back layer (630) comprises at least one high-refractive index layer (631) having a refractive index of above 1.65 and at least one low-refractive index layer (632) having a refractive index of below 1.65, wherein the high-refractive index layer (631) comprises a metal oxide, preferably a titanium oxide, and wherein the low-refractive index layer (632) comprises silica.
Clause 28. The optical assembly (10) of any of the clauses 4-27, wherein the heating element (600) includes an optically transparent coating (610) comprising at least one optically transparent front layer (640) arranged on the optically transparent conductive layer (620), wherein the optically transparent coating (610) has a refractive index of below 1.65.
Clause 29. The optical assembly (10) of any of the clauses 4-28, wherein the heating element (600) includes an optically transparent conductive layer (620) that is 10-1000 nm thick, optionally, 20-1000 nm thick, more optionally, 50-1000 nm thick.
Clause 30. The optical assembly (10) of any of the clauses 26-29, wherein the high-refractive index layer (631) is 5-30 nm thick, wherein the low-refractive index layer (632) is 9-90 nm thick, and wherein the optically transparent front layer (640) is 10-200 nm thick.
Clause 31. The optical assembly (10) of any preceding clause, wherein the optical body (100) comprises a plurality of optical elements including at least one optical element that comprises a front surface (111), a back surface (113, 114), and a side surface (112), wherein the front surface (111) is arranged facing the back surface (113, 114), the back surface (113, 114) comprising a first part (113) which is substantially perpendicular to an optical axis (O) of the optical body (100) and a second part (114) which is a curved part, wherein the side surface (112) abuts the front surface (111) and the back surface (113, 114), and wherein the optically transparent coating (310) is applied to at least one portion of one or more of the front surface (111), the side surface (112), and the back surface (113,114).
Clause 32. The optical assembly (10) of any preceding clause, 4-28, wherein the heating element (600) includes an optically transparent coating (610) applied to at least one of:
   - a portion of the front surface (111) and a portion of the side surface (112); and
   - a portion of the first part (113) of the back surface (113, 114) and a portion of the second part (114) of the back surface (113, 114).
Clause 33. The optical assembly (10) of the clause 31 or 32, wherein the attaching means (710) is arranged on the first part (113) of the back surface (113, 114) and/or the lateral surface (112).
Clause 34. The optical assembly (10) of any preceding clause, wherein the optical body (100) comprises one or more optical elements (110, 120, 130, 140, 150), a first optical element (110) being arranged further away from the electronic component (300) than the other optical elements (120, 130, 140, 150)), wherein the electronic component (300) is arranged between the first optical element (110) and the electronics carrier (500), the optical assembly (10) further comprising a heating element (600) arranged between the first optical element (110) and the electronic component (300).
Clause 35. A camera arrangement comprising the optical assembly (10) of any preceding clause and a connector or adapter to send image data to a further control unit.
Clause 36. The camera arrangement of clause 35 configured to be arranged on a vehicle.
Clause 37: A camera arrangement for a visual system, the camera arrangement comprising:
   - an optical assembly;
   - an electronics carrier (500);
   - an image sensor (850) coupled to the electronics carrier (500) and in optical communication with the optical assembly; and
   - an electronic component (300) coupled to the electronics carrier (500),

   wherein the electronic component (300) comprises at least one of:
      - one or more light sources (300') to emit light to the optical assembly (10), and
      - one or more light receivers (400) to receive light reflected from the optical assembly (10);
   wherein the camera arrangement is configured to acquire a video feed from an exterior field of view of a vehicle extending at least outside the vehicle, optionally capturing a portion of the exterior surface of the vehicle body;
   optionally, the camera arrangement further comprises a housing (200) adapted at least for receiving the optical assembly and enclosing the electronics carrier (500), the image sensor (850) and the electronic component (300); and
   optionally, the electronics carrier (500) comprises a first printed circuit board and a second printed circuit board, wherein the electronic component (300) is coupled to the first printed circuit board, and the image sensor is coupled to the second printed circuit board.
Clause 38. A method of making an optical assembly (10) comprising:
   - providing a housing (200) adapted at least to receive an optical body (100) comprising two or more optical elements (110, 120, 130, 140, 150) arranged one after the other along an optical axis (O);
   - coupling an electronic component (300) to an electronics carrier (500); and
   - inserting at least a portion of the electronics carrier (500) inside the housing (200) such that the electronics carrier (500) is arranged between said two or more optical elements (110, 120, 130, 140, 150)
   wherein the optical assembly (10) is a lens assembly, the optical body (100) is a lens body, and the housing (200) is a lens barrel.
Clause 39. A method of making an optical assembly (10) comprising:
   - providing a housing (200) adapted at least to receive an optical body (100) comprising one or more optical elements (110, 120, 13, 140, 150) along an optical axis (O);
   - coupling an electronic component (300) to an electronics carrier (500), the electronic component (300) comprising at least one of:
      - one or more light sources (300') configured to emit light towards the optical body (100), the optical body (100) being configured to reflect light from the light sources (300') when optical contamination (S) is located on the surface of the optical body; and
      - one or more light receivers (400) configured to receive the light reflected by the optical body (100) such that optical contamination (S) on the surface of the optical body is detected; and
   - providing the electronics carrier (500) behind at least one optical element (110) along the optical axis (O).
Clause 40. A method of making an optical assembly (10) comprising:
   - providing a housing (200) adapted to receive an optical body (100) comprising one or more optical elements (110, 120, 13, 140, 150);
   - coupling an electronic component (300) to an electronics carrier (500);
   - providing a heating element (600) between a portion of at least one optical element (110) and the electronics carrier (500) along the optical axis (O) for resistive heating of at least a portion of the optical body (100) as an electric current flows through; and
   - providing an electrical connecting means (700) configured to electrically connect the electronics carrier (500) and the heating element (600), preferably, at least one of:
      - the electrical connecting means (700) being part of or attached to the electronics carrier (500), and
      - the electrical connecting means (700) comprises a flexible element or a biasing element.
Clause 41. A method of detecting, and preferably removing, optical contamination (S) on an optical assembly (10) comprising the steps of:
   - acquiring a video feed from an exterior field of view of a vehicle extending at least outside the vehicle;
   - emitting, by a light source (300'), light towards an optical body (100), the optical body (100) being configured to reflect light from the light source (300') when optical contamination (S) is located on a surface of the optical body (100); and
   - receiving, by a light receiver (400), the light towards the optical body (100), the optical body (100) being configured to reflect light from the light source (300') when optical contamination (S) is located on the surface of the optical body (100);
   - detecting optical contamination (S) located on the surface of the optical body (100);
   - generating a heating instruction when optical contamination (S) has been detected; and
   - providing electric current to a heating element for resistive heating of at least a portion of the optical body (100) as an electric current flows through, preferably the heating element being optically transparent and electrically conductive.

A number of examples have been disclosed herein. However, other alternatives, modifications, uses and/or equivalents thereof are possible. Furthermore, all possible combinations of the described examples are also covered. Thus, the scope of the present disclosure should not be limited by examples but should be determined only by a fair reading of the claims that follow. If reference signs related to drawings are placed in parentheses in a claim, they are solely for attempting to increase the intelligibility of the claim and shall not be construed as limiting the scope of the claim.

## Claims

1. An optical assembly (10) comprising:
- an optical body (100);
- a housing (200) adapted at least to receive the optical body (100);
- an electronics carrier (500); and
- an electronic component (300) coupled to the electronics carrier (500).

2. The optical assembly (10) of claim 1, wherein the electronic component (300) comprises at least one of:
- one or more light sources (300') configured to emit light to the optical body (100), and
- one or more light receivers (400) configured to receive light reflected from the optical body (100).

3. The optical assembly (10) of claim 2, wherein the light source (300') is configured to emit light at a wavelength below 400 nm or above 760 nm.

4. The optical assembly (10) of any of the preceding claims, wherein the electronic component (300) is arranged between a main surface (521) of the electronics carrier (500) and a portion of the optical body (100).

5. The optical assembly (10) of any of the preceding claims, wherein, in use, the optical body (100) is intended to be in optical communication with an image sensor so as to acquire a captured image from an exterior field of view of a vehicle extending at least outside the vehicle.

6. The optical assembly (10) of any preceding claim, wherein the housing (200) encloses at least a portion of the electronics carrier (500), the electronic component (300), and the optical body (100), and wherein the housing (200) comprises a first coupling surface (201) for receiving at least one of: the electronics carrier (500), and attaching means for fixing the electronics carrier (500) in the housing.

7. The optical assembly (10) of any of the preceding claims, wherein the optical assembly (10) is a lens assembly, the optical body (100) is a lens body, the housing (200) is a lens barrel, and preferably, the optical body (100) comprises at least two optical elements (110, 120) between which the electronic component (300) is arranged.

8. The optical assembly (10) of any preceding claim, wherein the electronics carrier (500) is arranged within the optical assembly (10) at least partially extending around the optical body (100) and between opposite ends (111a, 111b) of the optical body (100).

9. The optical assembly (10) of any preceding claim, wherein the electronics carrier (500) is a flexible electronics carrier (500) comprising a first portion (510) extending in a direction substantially parallel to an optical axis (O) of the optical body (100), and a second portion (520) at least partially contained in a plane that is substantially perpendicular to the optical axis (O) of the optical body (100), preferably, the housing (200) comprises a passageway (250) formed therein for receiving at least one portion of the electronics carrier (500).

10. The optical assembly (10) of any preceding claim, wherein the optical assembly (10) further comprises a heating element (600) including a conductive body for resistive heating of at least a portion of the optical body (100) as an electric current flows through, preferably the conductive body includes an optically transparent coating applied to the optical body (100) with an optically transparent conductive layer.

11. The optical assembly of claim 10, wherein the optical assembly further comprises an electrical connecting means (700) for electrically connecting the electronics carrier (500) and the heating element (600).

12. The optical assembly (10) of claim 10 or 11, wherein the electronics carrier (500) includes at least an electric track for supplying electric power to the heating element (600), and at least one electric track for supplying electric power to the electronic component (300).

13. The optical assembly (10) of any preceding claim, wherein the optical assembly (10) is a camera arrangement, and the housing (200) is a camera housing, wherein the camera arrangement comprises an image sensor and a lens assembly that includes the optical body (100), wherein the image sensor is coupled to the electronics carrier and in optical communication with the optical assembly, and the electronics carrier (500) is enclosed within the camera housing (200).

14. Method of making an optical assembly (10), the method comprising:
- providing a housing (200) adapted at least to receive an optical body (100);
- coupling an electronic component (300) to an electronics carrier (500), the electronic component (300) comprising at least one of:
- one or more light sources (300') configured to emit light to the optical body (100), the optical body (100) being configured to reflect light from the light source (300') when optical contamination (S) is located on the surface of the optical body (100); and
- one or more light receivers (400) configured to receive the light reflected from the optical body (100) such that optical contamination (S) on the surface of the optical body (100) is detected;
and
- providing the electronics carrier (500) behind at least one optical element (110) of the optical body (100) along an optical axis (O) of the optical body (100);
and preferably
- inserting at least one portion of the electronics carrier (500) inside the housing (200) such that the electronics carrier (500) and the electronic component (300) are arranged between two optical elements (110) of the optical body (100).

15. Method of detecting optical contamination (S) on an optical assembly (10), the method comprising the steps of:
- preferably, acquiring a video feed from an exterior field of view of a vehicle extending at least outside the vehicle;
- emitting, by a light source (300'), a light to an optical body (100);
- receiving, by a light receiver (400), a light to the optical body (100), wherein said optical body (100) is configured to reflect light from the light source (300') when optical contamination (S) is located on a surface of the optical body (100); and
- detecting optical contamination (S) located on the surface of the optical body (100);
and preferably
- generating a heating instruction when optical contamination (S) has been detected; and
- providing electric current to a heating element (600) being electrically conductive for resistive heating of at least a portion of the optical body (100) as an electric current flows through.
